# DEMANDE DE BREVET EUROPEEN

(11) **EP 4 734 718 A1**
(43) Date de publication de la demande: **29.04.2026**
(21) Numéro de dépôt: 25208754.9
(22) Date de dépôt: 15.10.2025
(51) Int. Cl.: H10K 30/40, H10K 30/85, H10K 85/50, H10K 30/57

(54) **PROCEDE DE FABRICATION D'UN DISPOSITIF OPTOELECTRONIQUE**

(30) Priorité: 22.10.2024 FR 2411510
(71) Demandeur: Commissariat à l'Energie Atomique et aux Energies Alternatives, 75015 Paris (FR)
(72) Inventeur: ALCOCER, Kilian, 38054 Grenoble Cedex 09 (FR); DUPONT, Florian, 38054 Grenoble Cedex 09 (FR); BERSON, Solenn, 38054 Grenoble Cedex 09 (FR)
(74) Mandataire: Cabinet Beaumont

(57) **Abrégé**

La présente description concerne un procédé de fabrication d'un dispositif optoélectronique (100) comprenant une étape au cours de laquelle une couche en SnOₓN_{y} (152) avec x = 2,0 ± 1,0 et y = 1,0±0,75 est déposée sur une couche pérovskite (140).

Elle concerne également un dispositif optoélectronique (100) comprenant une couche en pérovskite (140) recouverte par une couche en SnOₓN_{y} (152) avec x = 2,0 ± 1,0 et y = 1,0 ± 0,75, de préférence y = 1,0 ± 0,5.

## Description

### Domaine technique

La présente description concerne de façon générale le domaine des dispositifs optoélectroniques, et plus particulièrement, des dispositifs optoélectroniques comprenant une couche en pérovskite, notamment les cellules photovoltaïques simple jonction ou les cellules photovoltaïques tandem silicium/pérovskite.

### Technique antérieure

Les cellules photovoltaïques à base de pérovskite comprennent une couche en transport des électrons (ETL pour 'Electron Transport Layer') située entre une couche en pérovskite et une électrode. La couche ETL permet d'extraire les électrons générés par la couche en pérovksite et de les transporter vers l'électrode.

La couche ETL est souvent formée d'un bicouche comprenant une couche d'extraction de type n et une couche tampon de type n. La couche tampon permet d'augmenter les performances de la cellule, en limitant les recombinaisons de charges aux interfaces entre la pérovskite et l'électrode supérieure. La couche tampon agit comme bloqueur de trous supplémentaire et comme barrière à la diffusion des ions (ions iodures notamment) de la pérovskite jusqu'à l'électrode, ce qui conduit à une amélioration de la stabilité de la cellule solaire (Mazumdar et al. "Stability of Perovskite Solar Cells: Degradation Mechanisms and Remedies" (2021), Frontiers in Electronics, 2, 712785).

Pour l'ETL des cellules solaires à base de pérovskite, plusieurs tampons peuvent être utilisés en bicouche avec le C₆₀ ou le PCBM, tels que la BCP, le LiF, ou les oxydes métalliques transparents et sélectifs, en particulier le SnO₂.

Dans le cas des cellules en configuration n-i-p, la couche ETL est formée avant la couche en pérovskite, ce qui permet un large choix de techniques de dépôt comme par exemple, les dépôts en voie liquide tel que le dépôt par bain chimique ou CBD (Mo et al., « Nitrogen - doped tin oxide electron transport layer for stable perovskite solar cells with efficiency over 23% » (2022), Interdisciplinary Materials, 1, 309-315.). Cependant, de telles techniques ne sont pas utilisables pour des cellules en configuration p-i-n. En effet, dans cette configuration, la couche en SnO₂ est formée après la couche en pérovskite, et cela nécessite de tremper toutes les couches sous-jacentes à la couche en SnO₂ dans la solution.

Pour les cellules en configuration p-i-n, et notamment, pour les tandems pérovskite/silicium p-i-n hautes performances, la couche en SnO₂ obtenue par dépôt de couches atomiques (ou ALD pour 'Atomic Layer Deposition') est l'ETL le plus répandu (Gao et al., « A review on monolithic perovskite/c-Si tandem solar cells: progress, challenges, and opportunities » (2022), J. Mater. Chem. A, 10, 10811-10828).

Cependant, le dépôt de SnO₂ par ALD nécessite une température supérieure à 80°C, ce qui peut dégrader les couches inférieures déjà formées, notamment la couche pérovskite. De plus, non seulement, la durée de dépôt d'une couche en 20 nm d'épaisseur en SnO₂ par ALD est longue, mais, en plus, elle nécessite un ultra vide couteux et requiert l'usage de précurseurs chimiques. Cette technique de dépôt est donc peu adaptée aux exigences industrielles.

Une autre technique pour déposer une couche d'oxyde métallique tel que le SnO₂ est la pulvérisation cathodique ('sputtering'). Cette méthode est plus rapide que l'ALD et les dépôts peuvent être réalisés à température ambiante. Cependant, la pulvérisation cathodique peut conduire à la dégradation de la surface de l'échantillon et à la croissance de couches moins qualitatives et moins uniformes que celles déposées par ALD, ce qui la rend moins adaptée en pratique.

Une méthode par voie physique (sans précurseurs chimiques) plus adaptée serait le dépôt par ablation laser pulsé ou PLD ('pulsed laser deposition"). En effet, une récente étude a démontré, pour des cellules pérovskites p-in simple jonction, que des couches de SnO₂ déposées par PLD, à température ambiante sous atmosphère de O₂, ont des performances équivalentes à des couches de SnO₂ déposées par ALD (Soltanpoor et al., « Low Damage Scalable Pulsed Laser Deposition of SnO2 for p-i-n Perovskite Solar Cells » (2023), Sol. RRL 7, 2300616).

Cette étude a également montré que les couches de pérovskites sur lesquelles sont déposées les couches de SnO₂ par PLD ne sont pas abimées. Cependant, le procédé PLD présenté requiert toujours un vide important (0,005 mbar) ainsi qu'une vitesse de dépôt relativement lente (28 min contre 52 min en ALD). Par conséquent, il n'y a pas encore de voie réellement industrialisable pour former la couche en SnO₂ après la couche active dans les cellules solaires pérovskite.

Actuellement, les ETL en configuration p-i-n sont donc généralement des couches en SnO₂ déposé par ALD.

### Résumé de l'invention

Il existe un besoin d'avoir un procédé de fabrication d'un dispositif optoélectronique comprenant une couche d'oxyde d'étain de bonne qualité, performante et facilement industrialisable.

Ce but est atteint par un procédé de fabrication d'un dispositif optoélectronique comprenant une étape au cours de laquelle une couche en SnOₓN_{y} avec x= 2,0 ± 1,0 et y= 1,0 ± 0,75 est déposée sur une couche en pérovskite.

Selon un mode de réalisation particulier, y= 1,0 ± 0,5.

Selon un mode de réalisation particulier, la couche en SnOₓN_{y} est déposée par ablation laser pulsée à partir d'une cible en présence d'un gaz ou d'un mélange de gaz.

Selon un mode de réalisation particulier, la cible est une cible de SnOₓN_{y} et le gaz est de l'argon.

Selon un mode de réalisation particulier, la cible est une cible de SnN_{y} et le gaz est de l'oxygène.

Selon un mode de réalisation particulier, la pression du gaz ou du mélange de gaz est comprise entre 0,03 et 0,2 mbar, de préférence entre 0,05 et 0,2 mbar, lors du dépôt par ablation laser pulsée.

Selon un mode de réalisation particulier, le dispositif optoélectronique est une cellule photovoltaïque de type p-i-n, par exemple une cellule photovoltaïque tandem silicium sur pérovskite ou une cellule photovoltaïque à simple jonction.

Selon un mode de réalisation particulier, la couche en pérovskite est en une pérovskite ayant pour formule ABX₃ avec A représentant un cation organique ou inorganique ou une combinaison de cations métalliques et/ou de cations organiques, A étant de préférence le cation formamidinium associé à un cation césium,
B représentant un ou plusieurs éléments métalliques, tels que le plomb, l'étain, le bismuth et l'antimoine, B étant de préférence du plomb,
X représentant un ou plusieurs anions, en particulier un ou plusieurs halogènes, et plus particulièrement choisis parmi le chlore, le brome, l'iode et leurs mélanges, X étant de préférence un mélange d'iode et de brome.

Selon un mode de réalisation particulier, une couche dopée n en PCBM ou en fullerène, de préférence en fullerène C60, est disposée entre la couche en pérovskite et la couche en SnOₓN_{y}.

Ce but est également atteint par un dispositif optoélectronique comprenant une couche en pérovskite recouverte par une couche en SnOₓN_{y} avec x= 2,0 ± 1,0 et y = 1,0 ± 0,75, de préférence y= 1,0 ± 0,5.

Selon un mode de réalisation particulier, la couche en pérovskite est formée d'une pérovskite ayant pour formule ABX₃ avec A représentant un cation organique ou inorganique ou une combinaison de cations métalliques et/ou de cations organiques,
B représentant un ou plusieurs éléments métalliques, tels que le plomb, l'étain, le bismuth et l'antimoine,
X représentant un ou plusieurs anions, en particulier un ou plusieurs halogènes, et plus particulièrement choisis parmi le chlore, le brome, l'iode et leurs mélanges, la pérovskite étant de préférence CsₓFA₁₋ₓPb(I_{y}Br_{1-y})₃ avec, de préférence, x < 0,17 et 0 < y < 1.

Selon un mode de réalisation particulier, l'épaisseur de la couche en SnOₓN_{y} est comprise entre 1 et 50 nm, de préférence entre 10 et 15 nm.

Selon un mode de réalisation particulier, le dispositif optoélectronique est une cellule photovoltaïque à simple jonction de type p-i-n, comprenant, par exemple, depuis une face soumise à un rayonnement lumineux :
- un substrat,
- une première électrode,
- une couche conductrice de type p,
- la couche en pérovskite,
- éventuellement, une couche dopée n, par exemple une couche en fullerène, notamment en fullerène C60,
- la couche en SnOₓN_{y},
- une deuxième électrode.

Selon un mode de réalisation particulier, le dispositif optoélectronique est une cellule photovoltaïque tandem pérovskite sur silicium de type p-i-n comprenant deux sous-cellules empilées l'une sur l'autre, une première sous-cellule étant une sous-cellule en pérovskite et une deuxième sous-cellule étant une sous-cellule en silicium, par exemple une sous-cellule à hétérojonction de silicium,
la première sous-cellule comprenant, par exemple, depuis une face soumise à un rayonnement lumineux :
- une électrode,
- la couche en SnOₓN_{y},
- éventuellement, une couche dopée n, par exemple une couche en PCBM ou en fullerène, notamment en fullerène C60,
- la couche en pérovskite,
- une couche conductrice de type p.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B représentent, de manière schématique et en coupe, une partie d'un dispositif optoélectronique, selon différents modes de réalisation particuliers de l'invention ;
la figure 2A représente, de manière schématique et en coupe, un dispositif optoélectronique, notamment une cellule solaire pérovskite à simple jonction de type p-i-n, selon un autre mode de réalisation particulier de l'invention ;
la figure 2B représente, de manière schématique et en coupe, un dispositif optoélectronique, notamment une cellule solaire tandem pérovskite/silicium de type p-i-n, selon un autre mode de réalisation particulier de l'invention ;
la figure 3 est un graphique représentant l'évolution de la résistivité du SnOₓN_{y} déposé par PLD en fonction de la pression de travail dans la chambre, sous N₂, selon un mode de réalisation particulier et de SnO₂ déposé par PLD sous O2 selon un exemple comparatif ;
la figure 4 représente l'évolution des ratio atomiques O/Sn et N/Sn quantifiés par spectrométrie de rétrodiffusion Rutherford (RBS) et analyse par réaction nucléaire (NRA), en fonction de la pression en N₂, selon un mode de réalisation particulier et en fonction de la pression en O₂ selon un exemple comparatif ;
la figure 5 est un graphique représentant les caractéristiques JV ('reverse bias') de cellules pérovskite simples jonctions, sous éclairement de 1 Soleil AM1.5, avec une couche en SnOₓN_{y} déposée par PLD sous N₂, selon un mode de réalisation particulier, et sous évaporation de BCP selon un exemple comparatif ;
la figure 6 est un cliché obtenu par FIB/STEM (HAADF) d'une couche en SnOₓN_{y} en cellule simple jonction p-i-n, selon un autre mode de réalisation particulier de l'invention ;
la figure 7 est une cartographie par EDX en coupe des éléments Sn (an bas à gauche), O (en haut à droite) et N (en bas à droite), de la couche en SnOₓN_{y} de la figure 6 ;
la figure 8 représente un profil chimique obtenu par EDX de la couche en SnOₓN_{y} de la figure 6 ;
la figure 9 est un graphique représentant les caractéristiques JV ('reverse bias') de cellules tandem PK/Si 9 cm² , sous éclairement 1 Soleil AM1.5, avec une couche PLD-SnOxNy déposée sous N₂, selon un mode de réalisation particulier, et sous évaporation de BCP selon un exemple comparatif.

Les différents éléments ne sont pas nécessairement représentés à une échelle uniforme pour rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par transparent, on entend que la structure ou l'élément considéré a une transmittance supérieure ou égale à 70 %, de préférence supérieure ou égale à 80% et encore plus préférentiellement supérieure ou égale à 90%. La transmittance représente l'intensité lumineuse traversant l'élément ou la structure sur le spectre du visible. Elle peut être mesurée par spectrométrie UV-Vis-IR. La transmittance du spectre du visible correspond à la transmittance pour des longueurs d'ondes comprise entre 350 et 800 nm.

Par compris entre X et Y, on entend que les bornes X et Y sont incluses.

Le procédé qui va être décrit plus en détail par la suite est un procédé de fabrication d'un dispositif optoélectronique 100. Le dispositif comprend au moins une couche en pérovskite (notée PK) 140.

Le dispositif optoélectronique 100 peut être un dispositif choisi parmi :
- un dispositif photovoltaïque : une cellule solaire simple jonction, une cellule solaire en configuration tandem (Silicium / pérovskite, pérovskite / pérovskite, CIGS / pérovskite) ou, de manière plus générale, une cellule solaire multijonction (SI/PK/PK),
- un capteur de lumière comprenant en outre des pérovskites, quantum dots (par exemple PbS), II-VI (par exemple CdTe), CIGS, semiconducteurs couches minces, OLED, ou semiconducteurs organiques,
- un émetteur de lumière : pérovskites, quantum dots (par exemple PbS), II-VI (par exemple CdTe), CIGS, semiconducteurs couches minces, OLED, ou semiconducteurs organiques,
- un dispositif photocatalytique,
- un dispositif pour la photo-électrolyse.

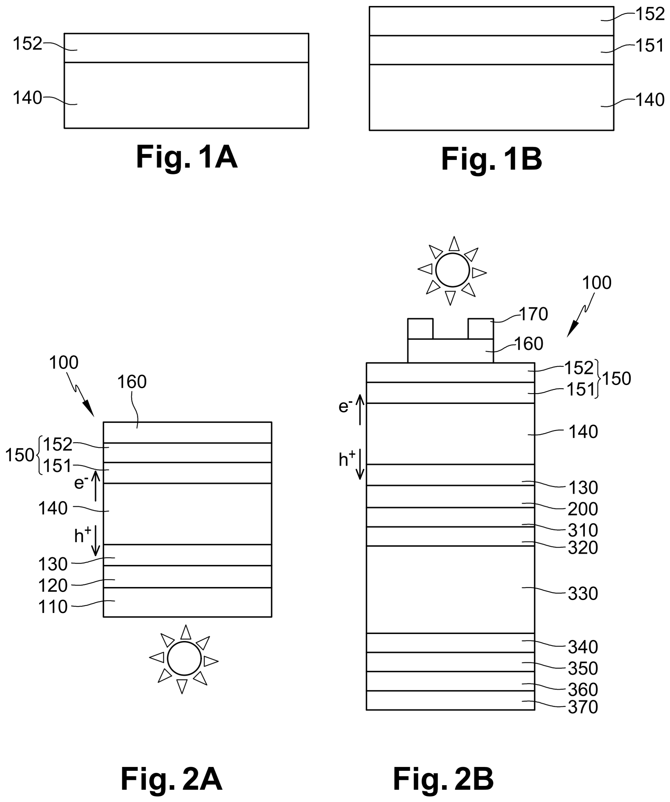

Le procédé comprend une étape au cours laquelle une couche en SnOₓN_{y} 152 est formée sur une couche en pérovskite 140 (figures 1A et 1B). La couche en SnOₓN_{y} 152 a pour formule SnOₓN_{y} avec x= 2,0 ± 1,0 et avec y= 1,0 ± 0,75 et de préférence y= 1,0 ± 0,5.

Une telle quantité d'azote dans la couche 152 empêche le matériau de devenir isolant, tout en maintenant la stœchiométrie désirée de l'oxyde et ses propriétés optoélectroniques recherchées. La couche en SnOₓN_{y} 152 se différencie d'une couche en SnO₂ dopé à l'azote par la quantité d'azote dans l'oxyde. Dans une couche dopée, la ratio N/Sn est de quelques pourcents (par exemple 2%), ce qui est plus de 10 fois plus faible, voire 50 fois plus faible, que le ratio N/Sn de la couche en SnOₓN_{y} de la présente invention.

La couche de SnOₓN_{y} 152 peut être dopée par un ou plusieurs éléments métalliques, par exemple, choisis parmi le fluor et le zirconium, pour améliorer les propriétés de la couche 152.

L'épaisseur de la couche 152 est, par exemple, comprise entre 1 nm et 50 nm, et de préférence entre 10 nm et 15 nm.

Une couche intermédiaire 151 peut être disposée entre la couche en pérovskite 140 et la couche en SnOₓN_{y} 152 (figure 1B). La couche intermédiaire peut être une couche en type n.

La couche en SnOₓN_{y} 152 peut être déposée par dépôt de couches atomiques (ALD) ou encore par une méthode de dépôt de type CVD (dépôt chimique phase vapeur). De telles méthodes conduisent à l'obtention d'une couche de qualité et présentant une bonne conformité.

La couche en SnOₓN_{y} 152 peut être déposée par d'autres méthodes de dépôt par voie physique en phase vapeur (PVD) telles que l'évaporation thermique ou par faisceau d'électrons (simple source ou multi sources), la pulvérisation cathodique ('sputtering') ou co-pulvérisation, ou encore la sublimation en espace clos ('close-space sublimation'). De telles méthodes de dépôt permettent de déposer des couches uniformes, cristallines et conformes, avec une forte vitesse de dépôt sous vide.

Il est également possible de déposer la couche en SnOₓN_{y} 152 par voie solvant (voie chimique liquide), par exemple avec une méthode de type dépôt à la tournette ('spin-coating'), enduction par trempage ('dipping'), impression ('printing'), dépôt par fente ('slot-die coating'), étalement au couteau ou dépôt par raclage ('doctor-blading'), impression par jet d'encre ('inkjet-printing'), pyrolyse par pulvérisation ('spray-pyrolysis'), sol-gel et dépôt par bain chimique. Ces méthodes de dépôt par voie liquide sont faciles et rapides à mettre en œuvre, tout en présentant un faible coût d'élaboration.

De préférence, la couche en SnOₓN_{y} 152 est déposée par ablation laser pulsée (PLD). Le dépôt par PLD ('pulsed laser deposition') est une technique de dépôt physique en phase vapeur (PVD), qui consiste à réaliser l'ablation d'un matériau cible (pour les oxydes, la cible est une cible céramique) à l'aide d'un laser pulsé en présence d'un gaz ou d'un mélange de gaz.

Plus précisément, les pulses laser peuvent être des pulses laser nanosecondes (par exemple 15 ns) émis à une fréquence contrôlée (par exemple comprise entre 10 et 100Hz). Les pulses laser sont dirigés vers la cible pour casser les liaisons entre les atomes, qui prennent alors la forme d'une plume de plasma de composition très proche de la cible (transfert stœchiométrique des espèces). La plume, générée perpendiculairement à la cible, en venant au contact d'un substrat choisi, donne lieu à la nucléation d'une couche sur le substrat, dans une chambre (ou enceinte) sous vide à atmosphère contrôlée.

Le laser UV (par exemple un laser UV Excimer KrF à 248 nm) consomme progressivement la cible selon un balayage défini. La plume parcourt le substrat (compatible wafer 300 mm) grâce à une rotation et translation de ce dernier, en le recouvrant uniformément. La fluence du laser (énergie surfacique incidente sur la cible en J/cm²) est gouvernée par la consigne d'énergie des pulses et le focus optique (ce dernier associé à une taille de spot, par exemple, de 5 à 10 mm² sur la cible) .

Lors du dépôt, la chambre de dépôt est sous haute pression de gaz ou de mélange de gaz, par exemple sous haute pression de N₂. Par haute pression, on entend ici que la pression de gaz ou du mélange de gaz est comprise entre 0,03 et 0,2 mbar, de préférence entre 0,05 et 0,2 mbar (c'est-à-dire entre 3 et 20 Pa, et de préférence entre 5 et 20 Pa).

La combinaison d'une haute pression en gaz ou mélange de gaz et d'une cible de stœchiométrie contrôlée permet d'obtenir la composition SnOₓN_{y}.

Par exemple, la combinaison d'une haute pression en azote et d'une cible de stœchiométrie SnO₂ permet d'obtenir la composition SnOₓN_{y}. L'atmosphère de dépôt est dépourvue de dioxygène. Elle est composée uniquement d'azote. L'oxygène est apporté par la cible et l'azote par le gaz dans l'enceinte.

Selon une autre variante de réalisation, la cible est une cible de stœchiométrie SnO₂ et un mélange de gaz contenant de l'azote, par exemple, un mélange azote/oxygène ou azote/argon est utilisé.

La couche mince SnOₓN_{y} peut également être obtenue avec une cible SnNₓ lors d'un dépôt sous O₂.

De telles pressions de gaz sont compatibles, d'une part, avec un niveau de vide moins exigeant (souvent reproché aux méthodes de dépôt sous vide), et, d'autre part, avec un procédé PLD capable de vitesses de dépôt élevées et d'une uniformité de dépôt même pour de grandes surfaces (par exemple avec des substrats 300mm/G12). Les substrats 300mm/G12 comprennent un substrat carré (format G12 (ou M12)) de 21x21cm² pouvant insérer à l'intérieur de l'empreinte d'un substrat disque ('wafer') de 300 mm de diamètre (295 mm).

De plus, cette méthode de dépôt évite d'utiliser des précurseurs chimiques, comme pour l'ALD.

De telles pressions permettent d'élaborer de façon plus industrialisable les couches de SnOₓN_{y}.

En particulier, de telles pressions sont avantageuses dans le cas de l'élaboration de couche en transport d'électrons (ETL) pour des cellules solaires pérovskite.

De préférence, les couches de SnOₓN_{y} 152 sont déposées à température ambiante (typiquement à une température comprise entre 20 et 25°C). La pérovskite sous-jacente n'est pas endommagée (dépôt dit 'low-damage'). Elles pourraient être déposées à une température supérieure, par exemple à une température pouvant aller jusqu'à 150°C.

Une étape de recuit peut être mise en œuvre après le dépôt de la couche en SnOₓN_{y} 152 pour améliorer la cristallinité de la couche. Une telle étape est, par exemple, réalisée pour des cellules solaires de type n-i-p, ou après le dépôt d'une couche en pérovskite inorganique 140.

Les couches obtenues ainsi obtenues par PLD présentent une faible résistivité et une stœchiométrie adaptée. De telles caractéristiques sont atteignables à haute pression, notamment sous N₂, mais ne seraient pas atteignables sous atmosphère O₂ conventionnelle.

De plus, les couches 152 obtenues présentent une bonne transparence.

Il est possible de déposer une couche en SnOₓN_{y} 152 ou plusieurs couches de SnOₓN_{y} avec différents paramètres d'élaboration pour obtenir un multicouche formé de plusieurs couches ayant des propriétés différentes.

Il est également possible d'élaborer une couche 152 avec un gradient de composition. Cela peut permettre, par exemple, de former une première partie de la couche de manière à préserver la couche ou les couches sous-jacentes (i.e. à ne pas la ou les endommager ; cette première partie jouant le rôle de couche tampon) ou de passiver des défauts d'interface pouvant être présents à la surface de la couche sous-jacente, puis de former une deuxième partie (formant les couches supérieures) pour avoir des propriétés électriques/optiques optimales. L'utilisation d'un multicouche peut permettre d'accorder les couches sous- et sus-jacentes, pour favoriser l'extraction ou l'injection des porteurs de charge, et/ou le confinement optique ou l'antireflet.

De telles couches peuvent être déposées dans le cadre de la fabrication de cellules solaires pérovskite. Les cellules solaires peuvent être des cellules simple jonction ou des cellules tandem. La couche en SnOₓN_{y} 152 du dispositif peut être une couche en transport de charges ou d'injection de charges.

Les cellules solaires peuvent être de type n-i-p ou de type p-i-n (structure dite de type inversé).

Le procédé de fabrication d'une cellule solaire en tandem à base de silicium-pérovskite (Si/PK) ou d'une cellule solaire à simple jonction mettant en œuvre une étape de dépôt d'une couche en SnOₓN_{y} déposée par PLD rend le dispositif très industrialisable (en comparaison d'une étape de dépôt par ALD).

Par exemple, la cellule solaire simple jonction p-i-n comprend successivement depuis la face soumise au rayonnement lumineux (figure 2A) :
- un substrat 110, de préférence transparent, par exemple en verre,
- une première électrode 120 dite électrode inférieure, de préférence transparente, par exemple une couche en oxyde transparent conducteur (TCO pour 'Transparent conductive Oxide'), notamment en oxyde d'indium et d'étain (ou ITO pour 'Indium Tin Oxide'),
- une couche conductrice de type p 130 (aussi appelée couche en transport de trous (HTL pour 'Hole Transport Layer'), par exemple en un carbazole , notamment le 2PACz (acide (2-(9H-carbazol-9-yl)éthyl)phosphonique)),
- une couche active en pérovskite 140,
- une couche conductrice de type n (aussi appelée couche en transport d'électrons (ETL pour 'Electrons Transport Layer'), par exemple formée d'un bicouche 150 comprenant une couche dopée n 151, par exemple une couche en fullerène, notamment en fullerène C60, et la couche en SnOₓN_{y} 152 ou par exemple formée de la couche en SnOₓN_{y} 152,
- une deuxième électrode 160 dite électrode supérieure en métal, par exemple en argent ou en aluminium.

Des contacts métalliques, par exemple en Cr/Au, sont formés sur le substrat 110 (non représentés). Ils peuvent être déportés.

L'éclairement se fait à travers le substrat 110.

La couche active 140 est une couche en matériau pérovskite de formule générale ABX₃ avec :
A représentant un cation organique ou inorganique ou une combinaison de cations métalliques et/ou de cations organiques,
B représentant un ou plusieurs éléments métalliques, tels que le plomb (Pb), l'étain (Sn), le bismuth (Bi) et l'antimoine (Sb),
X représentant un ou plusieurs anions, en particulier un ou plusieurs halogènes, plus particulièrement choisis parmi le chlore, le brome, l'iode et leurs mélanges.

De préférence, les pérovskites sont des pérovskites hybrides organiques-inorganiques. Dans de tels matériaux pérovskites, A comprend un ou plusieurs cations organiques peuvent être associés à un ou plusieurs cations métalliques, par exemple du césium et/ou du rubidium. Le ou les cations organiques peuvent être choisis parmi les cations alkyl-ammonium comme (par exemple un cation de type méthylammonium (MA)) et les cations formamidinium (FA).

De préférence, A représente le cation formamidinium (FA), éventuellement associé à du césium ; B est choisi parmi le plomb, l'étain, le bismuth, l'antimoine et leurs mélanges (de préférence le plomb) et X est choisi parmi le chlore, le brome, l'iode et leurs mélanges (de préférence un mélange d'iode et de brome).

Le matériau pérovskite peut être un composé de formule CsₓFA₁₋ₓPb(I_{1-y}Br_{y})₃ avec, par exemple, x < 0,17 ; 0 < y < 1 et FA symbolisant le cation formamidinium ou encore CsₓFA₁₋ₓPbI_{3-y}Br_{y} (avec 0 < y < 1 ou 0 < y < 3).

Dans le cas d'un bicouche, le fullerène C60 peut être remplacé par un autre matériau de type n, comme par exemple un polyéthylèneimine notamment le polyéthylènimine éthoxylé (PEIE), un thiophène comme le thiophène-C61-butyrate de méthyle, ou un autre fullerène, par exemple le C70, le fullerène C80, le fullerène C84.

Le matériau de type p pourrait aussi être choisi, par exemple, parmi les poly(styrène sulfonate) de sodium (PSS), les oxydes tels que WO3, MoO3, V2O5 et NiO, ou encore parmi les polymères pi-conjugués (tels que le poly(3,4-éthylènedioxythiophène) (PEDOT)et les poly(3-hexylthiophène) ou P3HT), ou un de leurs mélanges leurs mélanges.

Les cellules solaires de type pérovskite simple jonction de type p-i-n obtenues présentent un rendement photovoltaïque (PCE) de 14,3 %, pour une tension de circuit ouvert (V_{oc}) de 1032 mV, un courant de court-circuit (J_{sc}) de 21,9 mA/cm² et un facteur de forme (FF) de 63,1 %.

La cellule solaire tandem silicium pérovskite de type p-i-n est une structure comprenant deux sous-cellules empilées l'une sur l'autre. La sous-cellule supérieure est une sous-cellule en pérovskite tandis que la sous-cellule inférieure est en silicium, notamment il s'agit d'une sous-cellule à hétérojonction de silicium (figure 2B).

Les cellules photovoltaïques tandem pérovskite sur silicium pour maximiser l'efficacité de conversion de l'énergie solaire.

Les deux sous-cellules peuvent être séparées par une couche intermédiaire 200 électroniquement conductrice ou semi-conductrice, et de préférence, transparente au rayonnement électromagnétique. Elle peut être en un TCO (oxydes conducteurs transparents) choisis parmi, par exemple, l'ITO (oxyde d'indium-étain), l'AZO (oxyde d'aluminium-zinc), l'IZO (oxyde d'indium-zinc).

La sous-cellule à base de pérovskite comprend successivement depuis la face supérieure face exposée au soleil :
- une électrode dite électrode supérieure 160 de préférence transparente,
- une couche conductrice de type n (aussi appelée couche en transport d'électrons (ETL pour 'Electrons Transport Layer'), par exemple formée d'un bicouche 150 comprenant une couche dopée n 151 en fullerène, notamment en fullerène C60, et la couche 152 en SnOₓN_{y} en contact avec l'électrode supérieure, ou par exemple formée de la couche 152 en SnOₓN_{y},
- une couche active en pérovskite 140,
- une couche conductrice de type p 130 (HTL).

La sous-cellule à hétérojonction de silicium comprend, par exemple, depuis la couche intermédiaire 200 ou depuis la sous-cellule à base de pérovskite :
- une couche en silicium amorphe dopé n 310,
- de préférence une couche à base de silicium amorphe intrinsèque 320 servant de couche en passivation,
- un substrat en silicium cristallin dopé n 330,
- de préférence, une couche à base de silicium amorphe intrinsèque 340 servant de couche en passivation,
- une couche en silicium amorphe dopé p 350,
- une électrode 360, de préférence transparente.

Des contacts métalliques 370, par exemple en Cr/Au, sont formés sur l'électrode 360 de la sous-cellule à base de silicium et d'autres contacts métalliques 170 peuvent être formés sur l'électrode supérieure 160 de la sous-cellule à base de pérovskite. Ils peuvent être déportés au niveau de la face éclairée.

L'éclairement d'un dispositif tandem Si/PK est réalisé à partir de la sous-cellule à base de pérovskite.

Les matériaux précédemment décrit pour la cellule pérovskite simple jonction peuvent être utilisés pour la sous-cellule à base de pérovskite.

Les cellules solaires tandem p-i-n pérovskite sur silicium obtenues présentent un rendement photovoltaïque (PCE) de 20,0 %, pour une tension de circuit ouvert (V_{oc}) de 1766 mV, un courant de court-circuit (J_{sc}) de 16,6 mA/cm² et un facteur de forme (FF) de 68,1 %.

Des cellules de type p-i-n ont été particulièrement décrites. Les cellules solaires pourraient également être des cellules de type n-i-p à simple jonction ou des cellules tandem de type n-i-p. En effet, la méthode de dépôt de la couche en SnOₓN_{y}, notamment par PLD, peut être utilisée pour ces différentes structures puisque cette méthode nécessite un faible budget thermique, peut être mise en œuvre pour de nombreux substrats, et permet de former des couches stables et de composition désirée, ce qui est favorable à l'obtention de bonnes propriétés photovoltaïques. Les couches obtenues sont de stœchiométrie adaptée et ajustable, très peu rugueuses, de morphologie contrôlable (plus ou moins denses, colonnaires ou non). De ce fait, elles sont adaptées à la croissance subsidiaire d'une pérovskite pour des cellules n-i-p à simple jonction. Elles sont aussi adaptées à la contrainte thermique d'une sous-cellule hétérojonction de silicium (200°C max à cause du silicium amorphe) pour des cellules tandem n-i-p.

### Exemple illustratif et non limitatif

Dans ce premier exemple comparatif, le dépôt d'une couche d'un oxyde d'étain 152 a été réalisé par PLD sous O₂ et sous N₂.

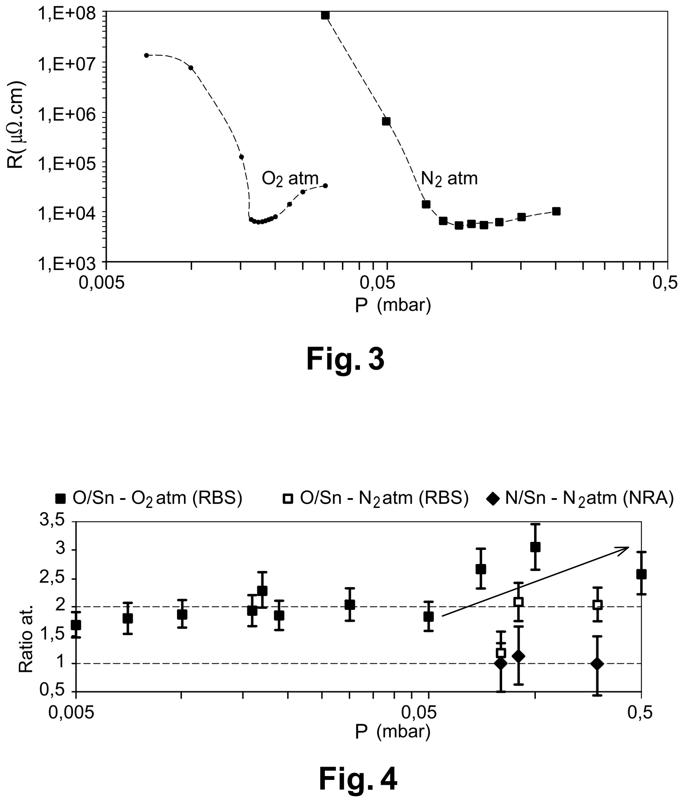

Pour le dépôt PLD sous O₂, dans un premier temps, la pression d'O₂ dans la chambre a été augmentée à partir de 0,005 mbar afin de réduire l'exigence du niveau de vide. La conductivité de la couche en SnO₂ formé augmente (i.e. la résistivité diminue) jusqu'à atteindre un maximum vers 0,017 mbar. L'ajout d'oxygène conduit ensuite rapidement à un remplissage des lacunes d'oxygène qui gouvernent la propriété de semi-conducteur de type n recherchée. La couche devient alors isolante, augmentant la résistivité au-delà de la plage de mesure (Figure 3).

De façon surprenante, il a été observé qu'un dépôt sous azote (N₂) permettait d'atteindre une haute conductivité sans recourir à un niveau de vide élevé. Il est donc possible d'obtenir un matériau présentant de bonnes propriétés électriques à haute pression en remplaçant l'oxygène par l'azote (Figure 3).

De plus, les couches obtenues ont été caractérisées par analyse chimique RBS pour déterminer leur stœchiométrie. L'augmentation de la pression d'O₂ conduit à un excès d'oxygène (responsable du caractère isolant) alors que le dépôt à haute pression sous N₂ dans la chambre conduit à une couche en SnOₓN_{y} ayant le ratio O/Sn désiré. Ainsi, un rapport N/Sn de 1 a pu être obtenu en réalisant un dépôt de SnO₂ par PLD sous azote à 0,15 mbar, tout en gardant un rapport O/Sn de 2. (Figure 4).

La présence d'azote dans la couche dans ces conditions a été confirmée par NRA (Figure 4), une variante de la RBS adaptée aux éléments légers.

Un dépôt de SnOₓN_{y} a ensuite été intégré en cellule solaire pérovskite simple jonction (par exemple une cellule photovoltaïque en configuration p-i-n telle que représentée sur la figure 2A). La cellule obtenue a été comparée avec la même cellule ayant un dépôt de BCP à la place de SnOₓN_{y}.

Le procédé de fabrication des cellules simples jonctions peut comprendre les étapes suivantes :
- lavage du substrat (notamment un substrat en verre recouvert d'une couche en ITO), à l'acétone, à l'IPA, puis à l'eau déionisée (EDI) sous ultrasons,
- dépôt des contacts Cr/Au sur l'ITO, par évaporation thermique sous vide (1.10⁻⁴ mbar) avec une vitesse de dépôt de 0.1 à 0.5 Å/s,
- traitement UV-ozone du substrat de 30 min,
- dépôt de la couche en type p en 2PACz, par dépôt à la tournette puis recuit à 100°C,
- dépôt de la couche en pérovskite, par dépôt à la tournette puis recuit à 100°C,
- dépôt d'une couche en C60 de 15 nm, par évaporation thermique sous vide (1.10⁻⁶ mbar) avec une vitesse de dépôt de 0.1 à 0.3 Å/s,
- dépôt de la couche en SnOₓN_{y} de 10 nm par ablation laser pulsé (PLD) à 4J/cm² et 50Hz, avec un flux de N₂ de 22 sccm correspondant à une pression de travail de 1,5.10⁻¹ mbar ; à titre comparatif, la couche en BCP a été déposée par évaporation thermique sous vide (1.10⁻⁶ mbar) avec une vitesse de dépôt de 0.1 à 0.3 Å/s pour la cellule de référence,
- dépôt de l'électrode supérieure d'Ag par évaporation thermique sous vide (5.10⁻⁶ mbar) avec une vitesse de dépôt de 0.5 à 1.5 Å/s.

En particulier, l'étape de dépôt de la couche en SnOₓN_{y} de 10 nm d'épaisseur sur la couche en C60, à partir d'une cible SnO₂ et sous haute pression d'azote, à température ambiante, peut comprendre au moins les sous-étapes suivantes :
- chargement des substrats/cellules dans l'enceinte (sur un substrat témoin de 200 mm ou sur un support ('holder') sur-mesure),
- isolement de l'enceinte, stabilisation de l'énergie du laser et démarrage de la consigne de pression de travail (haute pression de N₂ : 0,15 mbar à raison d'un flux de 22 sccm) ;
- dépôt de la couche à 50 Hz (50 pulses laser par seconde), en 5 allers-retours radiales de la plume de plasma sur le substrat de 200 mm (3 min 42 sec de dépôt) ;
- remise à l'équilibre de l'enceinte ;
- déchargement des substrats/cellules.

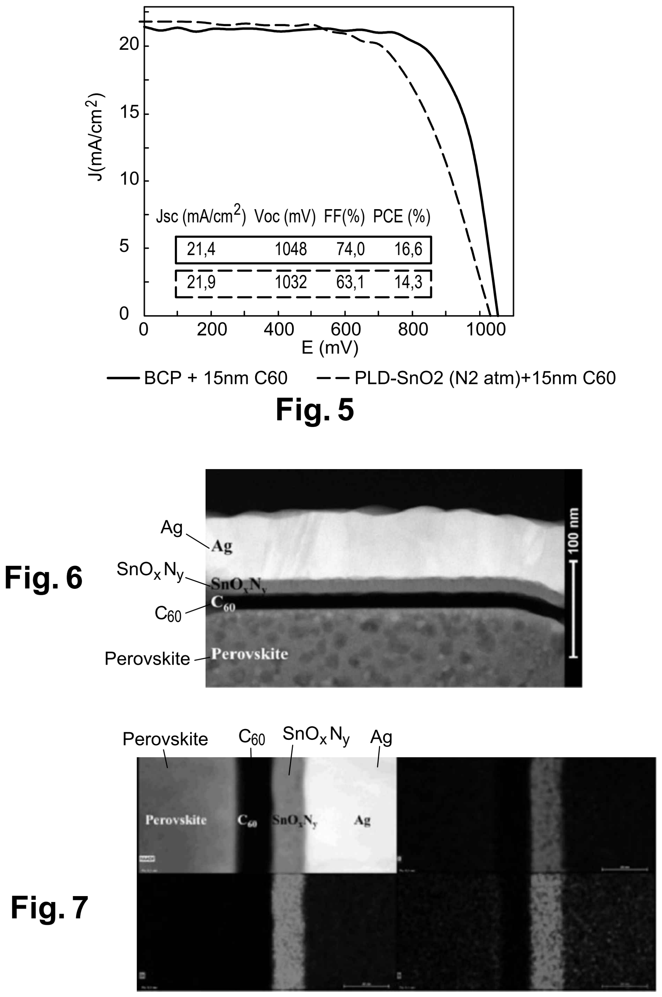

Les rendements de conversion des deux cellules ont été comparées (figure 5). La cellule avec la couche en SnOₓN_{y} déposé par PLD atteint un rendement de conversion photovoltaïque (PCE) de 14,3 % sous éclairement 1 soleil AM1.5 (1000 W/m²), soit une performance relative de 86 % par rapport à la cellule de référence avec du BCP comme ETL buffer.

Ceci confirme que les couches de SnOₓN_{y} peuvent être déposées sous haute pression d'azote. Le procédé est industrialisable. Les propriétés remarquables des couches de transport d'électrons (ETL) sont conservées, sans endommager la pérovskite sous-jacente.

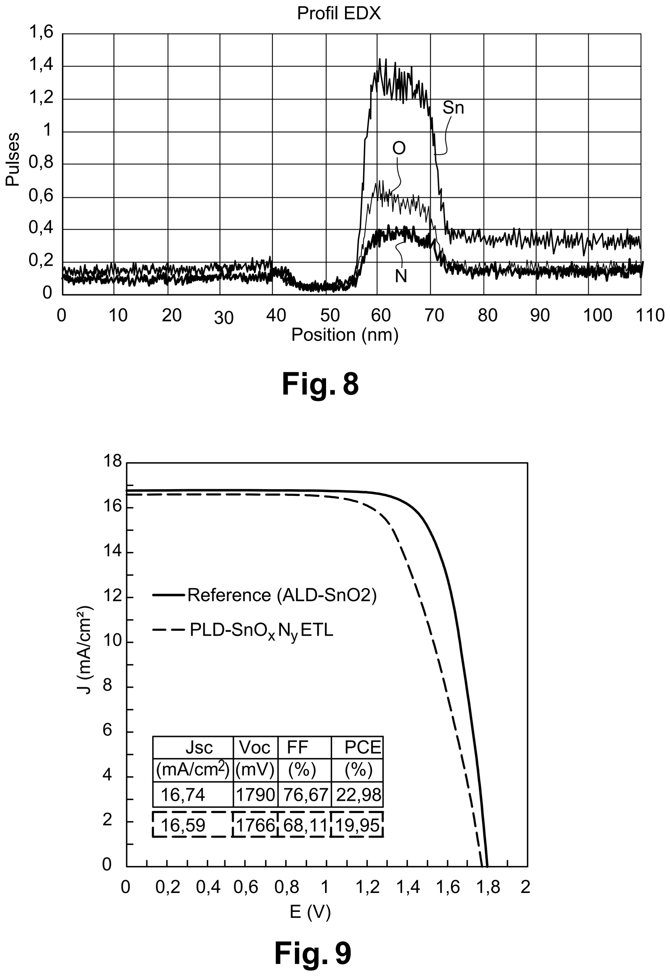

Une vue en coupe de la couche au sein de la cellule a été prise au microscope électronique en transmission à balayage (STEM), après coupe creusée au faisceau d'ions (FIB). Les images révèlent un dépôt d'une très bonne uniformité, au regard de la vitesse de dépôt élevée, sans détérioration des couches sous-jacentes et (Figures 6 et 7). Le profil chimique de la couche obtenue par EDX confirme la présence d'azote, uniforme sur l'épaisseur de la couche (Figure 8).

Enfin, l'étude a abouti à l'intégration de la couche en SnOₓN_{y} proposée en cellule tandem p-i-n (comme celle par exemple représentée sur la Figure 2B). Elle a une surface de 9 cm².

Le procédé de fabrication de la cellule tandem peut comprendre les étapes suivantes :
- dépôt de couches de silicium amorphe hydrogéné (passivant) intrinsèques et dopées (a-Si:H), par dépôt chimique en phase vapeur assisté par plasma (PECVD), de part et d'autre d'une plaque de c-Si type n de 6 pouces,
- dépôt d'une couche en ITO de 100 nm d'épaisseur, par pulvérisation magnétron à courant continu, sur le a-Si:H (p) pour la configuration p-i-n, afin de former le contact arrière,
- dépôt d'une fine couche en TCO sur l'a-Si:H (n) pour la configuration p-i-n, pour former la couche en recombinaison entre cellule inférieure et cellule supérieure,
- découpage des cellules inférieures en silicium en quatre échantillons de 50 mm x 50 mm,
- dépôt d'argent par évaporation thermique à l'arrière des échantillons pour former un contact sur toute la surface,
- dépôt d'une couche en 2PACz du côté du TCO de recombinaison par dépôt à la tournette et recuit à 100°C,
- dépôt d'une couche en pérovskite par dépôt à la tournette et recuit à 100°C,
- dépôt d'une couche en C60 par évaporation thermique sous vide (1.10⁻⁶ mbar) avec une vitesse de dépôt de 0.1 à 0.3 Â/s,
- dépôt de la couche en SnOₓN_{y} par ablation laser pulsé (PLD) à une fluence de 4 J/cm² et à 50 Hz, avec un flux de N₂ de 22 sccm correspondant à une pression de travail de 1,5.10⁻¹ mbar ; à titre comparatif, une couche en BCP dans une cellule de référence a été déposée par évaporation thermique sous vide (1.10⁻⁶ mbar) avec une vitesse de dépôt de 0.1 à 0.3 Å/s,
- dépôt d'une couche en ITO par pulvérisation cathodique (DC-sputtering) à 2500W avec un flux d'argon de 315 sccm et de O₂ de 6 sccm.
- dépôt d'une électrode supérieure en argent par évaporation thermique sous vide (1.10⁻⁶ mbar) avec une vitesse de dépôt de 5 Å/s.

Si le rendement n'atteint pas en l'état celui d'une référence avec SnO₂ par ALD, il n'en reste pas moins prometteur, car il atteint 20,0 % sous éclairement 1 soleil AM1.5 (1000 W/m²), soit une performance relative de 87 % par rapport à la référence (figure 9). Néanmoins, cela confirme que la couche en SnOₓN_{y} est utilisable dans une cellule tandem grande surface. Une optimisation future de la couche à partir de ce premier point de fonctionnement sera réalisée.

Le Tableau 1 ci-dessous répertorie les propriétés des cellules solaires obtenues avec une couche en SnO₂ de la littérature (par ALD ou PLD) et une couche en SnOₓN_{y} déposée par PLD sous N₂, en termes de figure de mérite, aisance de fabrication et propriétés optiques et électriques.

**[Table 1]**

| | ALD-SnO₂ | PLD-SnO₂ (O₂ pur) | PLD-SnOₓN_{y} (N₂ pur) |
|---|---|---|---|
| Facteur de mérite ou PCE (%) | 18,3 | 17,8 | 14,3 |
| Surface illuminée (cm²) | 0,01 | 0,01 | 0,13 |
| PCE (%) pour 9 cm² en tandem | 23,0 | - | 20,0 |
| Source de matériau | Précurseurs | Cible céramique | Cible céramique |
| Vide (mbar) | 0,00001 | 0,005 | 0,15 |
| Epaisseur (nm) | 24 | 19 | 10 |
| Vitesse de dépôt (nm/min) | 0,46 | 0,67 | 2,7 à 50 Hz (jusqu'à 16 à 300 Hz) |
| Durée de dépôt (min) | 52 | 28 | 3,7 à 50 Hz (environ 40s à 300 Hz) |
| Résistivité (Ω.cm) | - | 16 | 0,0076 |
| Transmittance au-dessus de 400 nm (%) | Supérieure à 84 | Supérieure à 65 | Supérieure à 83 |
| Bande interdite avec la méthode Tauc (eV) | 3,3 | 3,1 | 3,6 |

En plus des avantages liés au procédé de fabrication (niveau de vide notamment) et de la bonne conductivité obtenue, les couches ont une transmittance aussi élevée que leurs homologues obtenues par ALD et une énergie de bande interdite ('bandgap') plus élevée, qui permettrait un meilleur blocage des trous. De plus, le dépôt sous azote par PLD est 4 fois plus rapide que les dépôts de la littérature mentionnés.

Le travail de sortie et la bande de valence de SnOₓN_{y} ont été mesurés par une technique de spectroscopie de photoélectrons ultraviolets (UPS). Les résultats montrent un alignement de bande favorable à l'extraction des électrons et au blocage des trous.

Enfin, l'intégration en dispositif photovoltaïque n'a pas bénéficié de passivation d'interface, ni de surface d'éclairement aussi restreinte que dans la littérature, deux facteurs susceptibles de gonfler les performances.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de fabrication d'un dispositif optoélectronique (100) comprenant une étape au cours de laquelle une couche conductrice de type n (152) en SnOₓN_{y} avec x= 2,0 ± 0,5 et y= 1,0 ± 0,5 est déposée par dépôt physique en phase vapeur sur une couche en pérovskite (140).

2. Procédé selon la revendication précédente, dans lequel y= 1,0 ± 0,25 et de préférence y = 1,0 et/ou dans lequel x= 2,0 ± 0,25 et de préférence x = 2,0.

3. Procédé selon l'une des revendications précédentes, dans lequel la couche en SnOₓN_{y} (152) est déposée par ablation laser pulsée à partir d'une cible en présence d'un gaz ou d'un mélange de gaz.

4. Procédé selon la revendication 3, dans lequel la cible est une cible de SnOₓN_{y} et le gaz est de l'argon.

5. Procédé selon la revendication 3, dans lequel la cible est une cible de SnN_{y} et le gaz est de l'oxygène.

6. Procédé selon l'une des revendications 3 à 5, dans lequel la pression du gaz ou du mélange de gaz est comprise entre 0,03 et 0,2 mbar, de préférence entre 0,05 et 0,2 mbar, lors du dépôt par ablation laser pulsée.

7. Procédé selon l'une des revendications précédentes, dans lequel le dispositif optoélectronique (100) est une cellule photovoltaïque de type p-i-n, par exemple une cellule photovoltaïque tandem silicium sur pérovskite ou une cellule photovoltaïque à simple jonction.

8. Procédé selon l'une des revendications précédentes, dans lequel la couche en pérovskite (140) est en une pérovskite ayant pour formule ABX₃ avec A représentant un cation organique ou inorganique ou une combinaison de cations métalliques et/ou de cations organiques, A étant de préférence le cation formamidinium associé à un cation césium,
B représentant un ou plusieurs éléments métalliques, tels que le plomb, l'étain, le bismuth et l'antimoine, B étant de préférence du plomb,
X représentant un ou plusieurs anions, en particulier un ou plusieurs halogènes, et plus particulièrement choisis parmi le chlore, le brome, l'iode et leurs mélanges, X étant de préférence un mélange d'iode et de brome.

9. Procédé selon l'une des revendications précédentes, dans lequel la couche conductrice de type n (152) en SnOₓN_{y} est en contact direct avec la couche en pérovskite (140) ou dans lequel une couche dopée n (151) en PCBM ou en fullerène, de préférence en fullerène C60, est disposée entre la couche en pérovskite (140) et la couche conductrice de type n (152) en SnOₓN_{y}.

10. Dispositif optoélectronique (100) comprenant une couche en pérovskite (140) recouverte par une couche conductrice de type n (152) en SnOₓN_{y} avec x= 2,0 ± 0,5, de préférence x = 2,0 ± 0,25, et avec y= 1,0 ± 0,5, de préférence y= 1,0 ± 0,25.

11. Dispositif selon la revendication 10, dans lequel x= 2,0 et y = 1,0.

12. Dispositif selon l'une des revendications 10 ou 11, dans lequel la couche en pérovskite (140) est formée d'une pérovskite ayant pour formule ABX₃ avec A représentant un cation organique ou inorganique ou une combinaison de cations métalliques et/ou de cations organiques,
B représentant un ou plusieurs éléments métalliques, tels que le plomb, l'étain, le bismuth et l'antimoine,
X représentant un ou plusieurs anions, en particulier un ou plusieurs halogènes, et plus particulièrement choisis parmi le chlore, le brome, l'iode et leurs mélanges, la pérovskite étant de préférence CsₓFA₁₋ₓPb(I_{y}Br_{1-y})₃ avec, de préférence, x < 0,17 et 0 < y < 1.

13. Dispositif selon l'une des revendications 10 à 12, dans lequel l'épaisseur de la couche conductrice de type n (152) en SnOₓN_{y} est comprise entre 1 et 50 nm, de préférence entre 10 et 15 nm.

14. Dispositif selon l'une des revendications 10 à 13, dans lequel le dispositif optoélectronique (100) est une cellule photovoltaïque à simple jonction de type p-i-n, comprenant, par exemple, depuis une face soumise à un rayonnement lumineux :
- un substrat (110),
- une première électrode (120),
- une couche conductrice de type p (130),
- la couche en pérovskite (140),
- éventuellement, une couche dopée n (151), par exemple une couche en fullerène, notamment en fullerène C60,
- la couche conductrice de type n (152) en SnOₓN_{y},
- une deuxième électrode (160).

15. Dispositif selon l'une des revendications 10 à 13, dans lequel le dispositif optoélectronique (100) est une cellule photovoltaïque tandem pérovskite sur silicium de type p-i-n comprenant deux sous-cellules empilées l'une sur l'autre, une première sous-cellule étant une sous-cellule en pérovskite et une deuxième sous-cellule étant une sous-cellule en silicium, par exemple une sous-cellule à hétérojonction de silicium,
la première sous-cellule comprenant, par exemple, depuis une face soumise à un rayonnement lumineux :
- une électrode (160),
- la couche conductrice de type n (152) en SnOₓN_{y},
- éventuellement, une couche dopée n (151), par exemple une couche en PCBM ou en fullerène, notamment en fullerène C60,
- la couche en pérovskite (140),
- une couche conductrice de type p (130).
